# FASCICULE DE BREVET EUROPEEN

(11) **EP 0 509 436 B1**
(45) Date de publication et mention de la délivrance du brevet: **05.07.1995**
(21) Numéro de dépôt: 92106370.7
(22) Date de dépôt: 13.04.1992
(51) Int. Cl.: H01L 39/24

(54) **Procédé de fabrication d'un brin multifilamentaire à base d'oxydes supraconducteurs et brin obtenu par ce procédé**
Verfahren zum Herstellen von oxyd-supraleitenden multifilamentären Drähten und Drähte, erzeugt mit diesem Verfahren
Method of making an oxide superconductor multifilamentary wire and wire obtained by this method

(30) Priorité: 16.04.1991 FR 9104629
(43) Date de publication de la demande: 21.10.1992
(73) Titulaire: GEC ALSTHOM SA, 75116 Paris (FR)
(72) Inventeur: Dubots, Patrick, F-78640 Neauphle le Chateau (FR); Legat, Denis, F-91090 Lisses (FR)
(74) Mandataire: Weinmiller, Jürgen

(56) Documents cités:
- EP-A- 0 305 820
- EP-A- 0 401 461
- PATENT ABSTRACTS OF JAPAN vol. 13, no. 186 (E-752) 2 Mai 1989 ; & JP-A-1012415

## Description

La présente invention concerne un procédé de fabrication d'un brin multifilamentaire à base d'oxydes supraconducteurs, ainsi qu'un brin obtenu par ce procédé.

Les brins supraconducteurs à base d'oxydes à haute température critique sont classiquement réalisés de la manière suivante : De la poudre d'oxyde est introduite dans un tube métallique en alliage CuAl ou en argent, et l'ensemble est co-transformé par extrusion, étirage, tréfilage, ou martelage, puis laminage ou pressage. On obtient ainsi un brin monofilamentaire, à section cylindrique ou rectangulaire, dont les propriétés supraconductrices sont optimisées par un traitement thermique final (voir par exemple EP-A- 0 305 820).

Pour fabriquer des brins multifilamentaires, on part de tiges monofilamentaires, de section transversale choisie hexagonale, obtenues comme les brins monofilamentaires précédents ; on empile ces tiges dans un conteneur, leur section leur permettant d'aboutir à un remplissage maximum de ce conteneur. L'ensemble est co-transformé par les opérations mécaniques déjà mentionnées. Le processus complet est répété autant de fois que c'est nécessaire.

On constate que de tels brins multifilamentaires supraconducteurs ont des capacités de transport de courant limitées. Les sources de limitations dans ces brins sont multiples car, aux limitations propres aux céramiques d'oxydes supraconducteurs (liens faibles entre les grains, oxygénation...) s'ajoutent deux limitations propres à la multifilamentarisation. D'une part, les techniques utilisées, étirage, tréfilage, martelage, ne permettent pas de densifier suffisamment la poudre d'oxydes avant le traitement thermique final, ce qui se traduit par des fissurations infranchissables par le courant. D'autre part, ces procédés ne permettent pas de conférer aux filaments une section anisotrope. Or il a été montré que celle-ci est nécessaire à l'obtention de bonnes performances.

La présente invention a pour but de mettre en oeuvre un procédé de fabrication de brins multifilamentaires supraconducteurs à haute température critique permettant d'améliorer la densification de la poudre et de conférer une certaine anisotropie au matériau supraconducteur.

La présente invention a pour objet un procédé de fabrication d'un brin multifilamentaire à base d'oxydes supraconducteurs, procédé selon lequel on effectue les opérations suivantes :
- on réalise un "étage 0" en introduisant dans un tube métallique une poudre desdits oxydes, on fait subir à ce tube une transformation mécanique pour réduire ses cotes transversales, et on le tronçonne en tiges de courte longueur,
- on réalise un "étage 1" en juxtaposant lesdites tiges de courte longueur dans un conteneur métallique, et on effectue la même transformation mécanique et le même tronçonnage que pour ledit "étage 0",
- on réalise des "étages 2, 3...n", comme ledit "étage 1",
- on traite thermiquement "l'étage n" pour fritter ladite poudre, procédé caractérisé par le fait que ledit tube de "l'étage 0" et ledit conteneur des "étages 1, 2...n-1" ont une section transversale rectangulaire ou carrée et que, au niveau de chaque "étage" jusqu'à "l'étage n-1" ladite transformation mécanique pour réduire les cotes transversales est un étirage au travers d'une filière à galets assurant le maintien d'un profil transversal rectangulaire ou carré, le conteneur de "l'étage n" ayant au moins une section transversale interne rectangulaire ou carrée.

De préférence le conteneur de "l'étage n " est extérieurement cylindrique pour que soient facilitées des opérations supplémentaires ultérieures de tréfilage et de torsadage.

Le matériau du conteneur d'un "étage" dépend de la nature de matériau de "l'étage" précédent.

Selon un premier mode de réalisation ledit tube de "l'étage 0" est en argent, les conteneurs des "étages 1 à n-1" sont en argent, et le conteneur de "l'étage n" est en argent ou en alliage de cuivre et d'aluminium.

Selon un second mode de réalisation ledit tube de "l'étage 0" est en argent, les conteneurs des "étages 1 à n-1" sont en alliage de cuivre et d'aluminium et le matériau du conteneur de "l'étage n" est choisi parmi le cuivre, un alliage de cuivre et d'aluminium, l'acier inoxydable.

Selon un troisième mode de réalisation ledit tube de "l'étage 0" et les conteneurs des "étages 1 à n-1" sont en alliage de cuivre et d'aluminium et le matériau du conteneur de "l'étage n" est choisi parmi le cuivre, un alliage de cuivre et d'aluminium, l'acier inoxydable.

La présente invention a également pour objet un brin multifilamentaire obtenu par le procédé précédent, caractérisé par le fait qu'il comporte une pluralité de filaments supraconducteurs, présentant un facteur de forme supérieur ou égal à 4. (On appelle facteur de forme le rapport longueur/largeur de la section transversale des filaments).

Quels que soient les modes de réalisation, le procédé selon l'invention utilise des brins monofilamentaires à section rectangulaire ou carrée pour la réalisation des brins multifilamentaires, et met en oeuvre une filière à galets qui maintient la section rectangulaire ou carrée des filaments pendant tout le processus jusqu'au dernier étage. Ces caractéristiques permettent de favoriser la densification de la poudre et sa texturation lors du traitement de frittage. Ceci permet de limiter la formation des microfissures aux joints des grains lors du frittage, et donc d'accroître sensiblement la capacité de transport du courant de ces brins.

D'autres caractéristiques et avantages de la présente invention apparaîtront au cours de la description suivante d'un mode de réalisation donné à titre illustratif mais nullement limitatif.

Dans le dessin annexé apparaît très schématiquement en coupe l'évolution d'un brin multifilamentaire au cours de quelques phases du procédé selon l'invention. Les dimensions et les échelles ne sont pas du tout respectées sur le schéma.

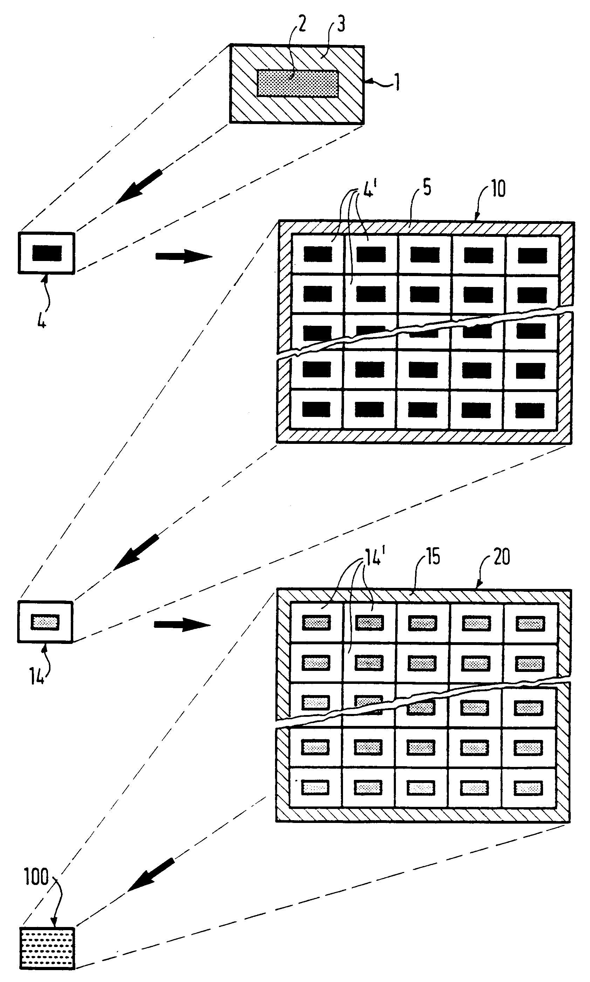

On voit dans la figure 1 "l'étage 0" référencé 1. Un tube 3 en argent, de section rectangulaire est rempli de poudre 2 d'oxyde YBa₂Cu₃O₇. Après étirage dans une filière à galets, on obtient un brin monofilamentaire 4 où le filament central a alors les dimensions 0,6 x 1,2 mm et le tube extérieur les dimensions 1 x 2 mm. Le filament central est entouré d'une gaine d'oxyde d'argent de 60 microns d'épaisseur.

Le brin 4 est tronçonné en 50 tiges 4' empilées en cinq rangées de dix dans un conteneur 5 en alliage de cuivre et d'aluminium de section carrée, de cote intérieur 10 mm et de cote extérieur 12 mm. On a ainsi réalisé "l'étage 1" référencé 10.

On effectue un nouvel étirage dans une filière à galets maintenant un profil rectangulaire et on obtient un brin multifilamentaire 14 de cotes 0,6 x 1,2 mm.

Ce brin comporte 50 filaments supraconducteurs de dimensions transversales 30 x 120 micromètres, soit un facteur de forme de 4.

On peut augmenter le facteur de forme des filaments en recommençant le processus pour réaliser un "étage 2" référencé 20 avec un conteneur 15 en alliage de cuivre et d'aluminium. Pour cela, on stoppe la fabrication du brin 14 lorsqu'il présente les cotes transversales de 1 x 2 mm ; on le tronçonne en 50 tiges 14′ empilées en cinq rangées de 10 dans un conteneur 15 en alliage de cuivre et d'aluminium de section carrée de cotes intérieures 10 mm et de cotes extérieures 12 mm.

On effectue un nouvel étirage dans une filière à galets maintenant un profil rectangulaire et on obtient un brin multifilamentaire 100. Le brin, de section 1,2 x 2,4 mm compte 2500 filaments supraconducteurs de dimensions 5 x 40 micromètres, soit un facteur de forme de 8, ce qui est sensiblement supérieur aux facteurs de forme de 2 à 3 classiquement obtenus dans les brins multifilamentaires.

Le facteur de forme élevé permet de multiplier par un facteur au moins égal à 3 la densité de courant critique dans le filament supraconducteur, et dépasser ainsi les 3000 A/cm² à 77K.

## Revendications

1. Procédé de fabrication d'un brin multifilamentaire à base d'oxydes supraconducteurs, procédé selon lequel on effectue les opérations suivantes :
- on réalise un "étage 0" en introduisant dans un tube métallique une poudre desdits oxydes, on fait subir à ce tube une transformation mécanique pour réduire ses cotes transversales, et on le tronçonne en tiges de courte longueur,
- on réalise un "étage 1" en juxtaposant lesdites tiges de courte longueur dans un conteneur métallique, et on effectue la même transformation mécanique et le même tronçonnage que pour ledit "étage 0",
- on réalise des "étages 2, 3...n", comme ledit "étage 1",
- on traite thermiquement "l'étage n" pour fritter ladite poudre, procédé caractérisé par le fait que ledit tube de "l'étage 0" et ledit conteneur des "étages 1, 2...n-1" ont une section transversale rectangulaire ou carrée et que, au niveau de chaque étage jusqu'à "l'étage n-1", ladite transformation mécanique pour réduire les cotes transversales est un étirage au travers d'une filière à galets assurant le maintien d'un profil transversal rectangulaire ou carré, le conteneur de "l'étage n" ayant au moins une section transversale interne rectangulaire ou carrée.

2. Procédé selon la revendication 1, caractérisé par le fait que le conteneur de "l'étage n" est extérieurement cylindrique.

3. Procédé selon l'une des revendications 1 et 2, caractérisé par le fait que ledit tube de "l'étage 0" est en argent, que les conteneurs des "étages 1 à n-1" sont en argent, et que le conteneur de "l'étage n" est en argent ou en alliage de cuivre et d'aluminium.

4. Procédé selon l'une des revendications 1 et 2, caractérisé par le fait que ledit tube de "l'étage 0" est en argent, que les conteneurs des "étages 1 à n-1" sont en alliage de cuivre et d'aluminium et que le matériau du conteneur de "l'étage n" est choisi parmi le cuivre, un alliage de cuivre et d'aluminium, l'acier inoxydable.

5. Procédé selon l'une des revendications 1 et 2, caractérisé par le fait que ledit tube de "l'étage 0" et les conteneurs des "étages 1 à n-1" sont en alliage de cuivre et d'aluminium et que le matériau du conteneur de "l'étage n" est choisi parmi le cuivre, un alliage de cuivre et d'aluminium, l'acier inoxydable.

6. Brin obtenu par le procédé selon l'une des revendications précédentes, caractérisé par le fait qu'il comporte une pluralité de filaments supraconducteurs présentant un facteur de forme supérieur ou égal à 4.

## Patentansprüche

1. Herstellungsverfahren für einen vieladrigen Draht auf der Basis von supraleitenden Oxiden, bei dem die folgenden Verfahrensschritte durchgeführt werden:
- in einer "Stufe 0" wird in ein Metallrohr ein Pulver der Oxide eingeführt, dann wird dieses Rohr einer mechanischen Transformation unterzogen, um seinen Querschnitt zu verringern, und dann wird es in kurze Stäbe zerteilt,
- in einer "Stufe 1" werden die kurzen Stäbe in einem Metall-Container nebeneinander angeordnet, und dann werden die gleiche mechanische Transformation und die gleiche Zerteilung wie in der "Stufe 0" durchgeführt,
- es erfolgen "Stufen 2, 3, ... n" wie die "Stufe 1",
- in der "Stufe n" erfolgt eine Wärmebehandlung, um das Pulver zu sintern,
dadurch gekennzeichnet, daß das Rohr in der "Stufe 0" und der Container der "Stufen 1, 2 ... n-1" einen rechteckigen oder quadratischen Querschnitt haben und daß in Höhe jeder Stufe" bis zur "Stufe n-1" die mechanische Transformation zur Verringerung des Querschnitts ein Strecken mittels einer Rollen-Ziehdüse ist, bei dem ein rechteckiges oder quadratisches Querprofil erhalten bleibt, wobei der Container der "Stufe n" mindestens einen rechteckigen oder quadratischen inneren Querschnitt hat.

2. Verfahren nach Anspruch 1, dadurch gekennzeichnet, daß der Container der "Stufe n" außen zylindrisch ist.

3. Verfahren nach einem der Ansprüche 1 und 2, dadurch gekennzeichnet, daß das Rohr der "Stufe 0" aus Silber ist, die Container der "Stufen 1 bis n-1" aus Silber sind und daß der Container der "Stufe n" aus Silber oder einer Aluminium-Kupfer-Legierung ist.

4. Verfahren nach einem der Ansprüche 1 und 2, dadurch gekennzeichnet, daß das Rohr der "Stufe 0" aus Silber ist, daß die Container der "Stufen 1 bis n-1" aus einer Aluminium-Kupfer-Legierung sind und daß das Material des Containers der "Stufe n" aus Kupfer, einer Aluminium-Kupfer-Legierung und rostfreiem Stahl ausgewählt wird.

5. Verfahren nach einem der Ansprüche 1 und 2, dadurch gekennzeichnet, daß das Rohr der "Stufe 0" und die Container der "Stufen 1 bis n-1" aus einer Aluminium-Kupfer-Legierung sind und daß das Material des Containers der "Stufe n" aus Kupfer, einer Aluminium-Kupfer-Legierung und rostfreiem Stahl ausgewählt wird.

6. Nach dem Verfahren gemäß einem der vorhergehenden Ansprüche erhaltener Draht, dadurch gekennzeichnet, daß er eine Vielzahl von supraleitenden Adern aufweist, die einen Formfaktor von mindestens 4 haben.

## Claims

1. A method of manufacturing a multifilament strand based on superconductive oxides, said method consisting in the following steps:
a "stage 0" is made by inserting said oxides in powder form into a metal tube, the tube is subjected to mechanical transformation so as to reduce its cross-sectional dimensions, and it is cut up into short rods;
a "stage 1" is made by juxtaposing said short rods inside a metal container, and the same mechanical transformation step and the same cutting-up step are performed as for said "stage 0";
"stages 2, 3, ..., n" are made in the same way as said "stage 1"; and
"stage n" is heat treated to sinter said powder;
said method being characterized by the fact that said tube in "stage 0" and said container in "stages 1, 2, ..., n-1" are rectangular or square in cross section, and at each stage up to "stage n-1", said mechanical transformation for reducing the cross-sectional dimensions consists in drawing through a Turk's head roll die maintaining a rectangular or square profile, the container in "stage n" being rectangular or square at least in inside cross-section.

2. A method according to claim 1, characterized by the fact that the container in "stage n" is externally cylindrical.

3. A method according to claim 1 or 2, characterized by the facts that said tube in "stage O" is made of silver, that the containers in "stages 1 to n-1" are made of silver, and that the container in "stage n" is made either of silver or of an alloy of copper and aluminum.

4. A method according to claim 1 or 2, characterized by the facts that said tube in "stage 0" is made of silver, that the containers in "stages 1 to n-1" are made of an alloy of copper and aluminum, and that the material of the container in "stage n" is chosen from copper, an alloy of copper and aluminum, and stainless steel.

5. A method according to claim 1 or 2, characterized by the facts that said tube in "stage 0" and the containers in "stages 1 to n-1" are made of an alloy of copper and aluminum, and that the material of the container in "stage n" is chosen from copper, an alloy of copper and aluminum, and stainless steel.

6. A strand obtained by performing the method according to any preceding claim, said strand being characterized by the fact that it comprises a plurality of superconductive filaments each having an aspect ratio of not less than 4.
